# FASCICULE DE BREVET EUROPEEN

(11) **EP 3 200 664 B1**
(45) Date de publication et mention de la délivrance du brevet: **09.06.2021**
(21) Numéro de dépôt: 15788109.5
(22) Date de dépôt: 28.09.2015
(51) Int. Cl.: A47J 36/06, A47J 37/10, A47J 45/06

(54) **POIGNÉE COMPRENANT UN GÉNÉRATEUR THERMOÉLECTRIQUE**
GRIFF MIT EINEM THERMOELEKTRISCHEN GENERATOR
HANDLE COMPRISING A THERMOELECTRIC GENERATOR

(30) Priorité: 30.09.2014 FR 1459228
(43) Date de publication de la demande: 09.08.2017
(73) Titulaire: SEB S.A., 69130 Ecully (FR)
(72) Inventeur: COMPEAU, Jean-Louis, 38070 Saint Quentin Fallavier (FR); LINGLIN, Benoît, 74370 Saint Martin Bellevue (FR)
(74) Mandataire: SEB Développement
(86) Numéro de dépôt international: PCT/FR2015/052575
(87) Numéro de publication internationale: WO 2016/051056

(56) Documents cités:
- EP-A1- 2 361 538
- EP-A1- 2 606 791
- WO-A1-2009/147688
- WO-A1-2013/130365
- WO-A2-2004/008923
- FR-A1- 2 977 121
- US-A1- 2007 228 056
- US-A1- 2008 290 104

## Description

L'invention se situe dans le domaine des poignées pour des récipients de cuisson (appelés également récipients) ou pour des couvercles de récipients de cuisson, appelés simplement couvercles. L'invention concerne plus particulièrement des poignées intégrant des dispositifs de fourniture d'électricité dans le but d'alimenter des fonctions électroniques et qui fonctionnent sur le principe de la conversion thermoélectrique.

On connait déjà des récipients de cuisson comme par exemple des poêles à frire qui utilisent un dispositif de fourniture d'électricité tel qu'un générateur thermoélectrique pour alimenter un système électronique d'indication de température situé dans la poignée. Lorsque les poêles à frire sont chauffées un flux thermique se crée. Le générateur thermoélectrique utilise ce flux thermique pour produire de l'électricité nécessaire au fonctionnement du système électronique d'indication.

Le document EP 2 606 791 A1 montre une poignée selon le préambule de la revendication 1. Le document CN201015533 divulgue une poêle électronique qui comprend un corps de poêle, également appelé jupe, ainsi qu'une poignée qui est positionnée de manière fixe à ce corps de poêle. La poêle comprend également un capteur de température et cette température peut être affichée sur un afficheur intégré dans la poignée. Afin d'alimenter ce capteur et cet afficheur, la poêle comprend un générateur thermoélectrique qui génère de l'électricité pour le fonctionnement du capteur et de l'afficheur. Ce générateur thermoélectrique comprend deux faces dont une est positionnée contre la jupe de la poêle. Afin d'assurer un couplage thermique optimal, le générateur thermoélectrique est mis en contrainte contre le corps de la poêle. La jupe de la poêle va constituer une source chaude pour le générateur thermoélectrique. Ce document divulgue également un dissipateur thermique destiné à favoriser le refroidissement du générateur thermoélectrique et ainsi à créer une source froide nécessaire au fonctionnement du générateur thermoélectrique. Ce dissipateur thermique a la forme d'un radiateur métallique qui comprend des ailettes montées verticalement dans la poignée afin de créer un courant d'air de refroidissement par convection et un échange d'air suffisant avec l'air ambiant. Le radiateur est confiné à l'extrémité de la poignée qui est la plus proche de la source chaude, c'est-à-dire l'extrémité de la poignée qui est la plus proche de la poêle.

Une telle architecture de poignée comporte un certain nombre d'inconvénients.

Pour qu'un tel radiateur puisse établir une source froide suffisante pour créer un courant électrique dans le générateur thermoélectrique, il faut que les ailettes aient un dimensionnement suffisant pour bien évacuer la chaleur. Comme celles-ci sont montées verticalement dans la poignée, la hauteur de ces ailettes, et donc le rendement du générateur thermoélectrique, est alors limité par la hauteur de la poignée.

Un autre inconvénient est dû à la position de ce radiateur dans la poignée et au fait qu'il soit confiné dans une partie creuse de la poignée qui est positionnée à l'extrémité de la poignée qui est la plus proche de la poêle et donc de la source chaude. L'air circulant dans cette zone est plutôt très chaud du fait de sa convection sur la jupe de la poêle, du plan de cuisson sur lequel on chauffe la poêle, voire du mélange avec des gaz de combustion dans le cas d'un foyer flamme. Ceci induit que la convection de l'air, nécessaire à l'établissement de la source froide (par le refroidissement du radiateur) peut être perturbée. On constate par ailleurs qu'au bout d'un certain temps de chauffage de la poêle, la zone dans laquelle se trouve le radiateur est trop chaude pour que le radiateur puisse évacuer suffisamment de chaleur et le générateur thermoélectrique n'est plus à même de produire de l'électricité.

La présente invention vise à résoudre ces inconvénients en proposant de créer une zone de convection naturelle apte à refroidir un dissipateur thermique par un échange thermique suffisant et constant au cours du temps avec l'air ambiant, tout en maintenant la température de la surface externe de la poignée conforme à son utilisation en tant qu'organe de préhension.

A cet effet l'invention propose d'utiliser une zone peu sensible à la circulation de gaz chauds qui peut se produire sur les foyers à gaz et à proximité de la source chaude. L'idée consiste en particulier à utiliser une grande partie du volume et de la surface de la poignée pour assurer cet échange thermique.

Ce but est atteint à l'aide d'une poignée pour récipient de cuisson ou couvercle comprenant au moins un générateur thermoélectrique relié thermiquement à un dissipateur thermique ; la poignée comprend une cavité intérieure qui s'étend longitudinalement sur au moins un tiers de la longueur de la poignée et le dissipateur thermique s'étend longitudinalement dans la cavité et dans au moins deux tiers de la longueur de la cavité.

Selon une caractéristique de l'invention, le dissipateur thermique est composé d'une ou plusieurs ailettes.

Selon une caractéristique de l'invention, les ailettes sont métalliques et sont soit en aluminium soit en cuivre.

Selon une variante de réalisation, les ailettes sont des caloducs.

Selon une caractéristique de l'invention, la cavité comprend une ou plusieurs ouvertures qui débouchent vers l'extérieur.

Selon une caractéristique de l'invention, la poignée comprend une ou plusieurs grilles de protection positionnées sur les ouvertures.

Selon une caractéristique de l'invention, la poignée comprend une pièce de jonction entre le générateur thermoélectrique et le dissipateur thermique.

Selon une caractéristique de l'invention, la poignée comprend un dispositif électronique relié au générateur thermoélectrique.

Selon une caractéristique de l'invention, le dispositif électronique peut être un afficheur électronique ou un capteur électronique.

Selon une caractéristique de l'invention, la poignée comprend un micro ventilateur relié au générateur thermoélectrique.

On comprendra mieux les buts, aspects et avantages de la présente invention, d'après la description donnée ci-après d'un mode particulier de réalisation de l'invention présenté à titre d'exemple non limitatif, en se référant aux dessins annexés dans lesquels :
- la figure 1 est une vue éclatée d'une poignée pour récipient de cuisson ;
- la figure 2 est une vue en coupe de profil d'une poignée pour récipient de cuisson ;
- la figure 3 est une vue en coupe AA de la figure 2.

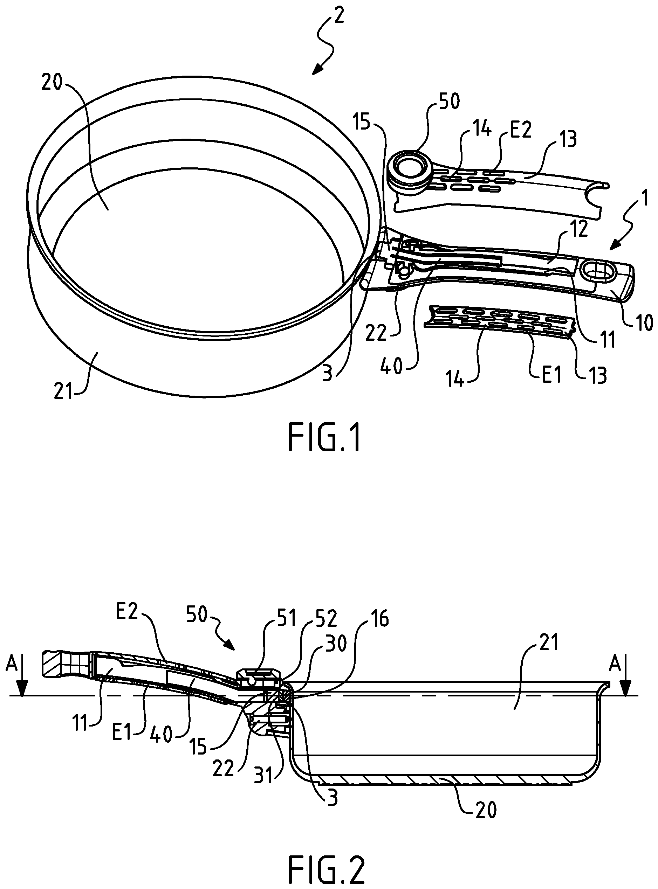

En lien avec la figure 1, le récipient (2) de cuisson (ou récipient) comprend un fond (20) et une paroi (21) qui entoure le fond (20). Ce récipient (2) peut être une poêle mais peut également être une casserole, un faitout ou tout autre contenant métallique destiné à être chauffé thermiquement au niveau du fond (20). Par exemple le récipient (2) peut être fait en aluminium.

Le récipient (2) comprend en outre une poignée (1) qui est fixée sur la paroi (21) par un système (22) de fixation. Le système (22) de fixation est un système mécanique de goujons, de vis ou de rivets.

De manière plus précise, la poignée (1) comprend un corps principal (10). De façon préférentielle celui-ci est fait dans un matériau thermostable afin de limiter son échauffement. Le corps principal (10) de la poignée (1) peut également être fait dans tout matériau non conducteur de chaleur.

Le corps principal (10) est évidé à l'intérieur et dans la longueur de la poignée (1) de manière à obtenir une cavité (11) intérieure (ci-après dénommée simplement cavité) qui contient des ailettes (40) qui seront détaillées par la suite. Afin que la cavité (11) remplisse sa fonction de refroidissement, celle-ci doit être suffisamment grande pour pouvoir évacuer assez de chaleur. A cet effet la cavité (11) s'étend longitudinalement dans la poignée (1) et sur au moins un tiers de la longueur de la poignée (1) créant ainsi un volume minimal nécessaire à la fonction de refroidissement. La cavité (11) peut également courir sur toute la longueur de la poignée (1).

La cavité (11) comprend une ouverture (12) supérieure et une autre inférieure qui débouchent vers l'extérieur de part et d'autre de la poignée (1) et qui s'étendent sur une partie de la longueur de celle-ci.

Des grilles (13) de protection viennent fermer la cavité (11) au niveau de ces ouvertures (12) inférieures et extérieures et ceci afin qu'un utilisateur ne puisse pas accéder à l'intérieur de la cavité (11) et aux ailettes (40). En outre, ces grilles (13) comportent des ouvertures (14) pour l'aération de la cavité (11).

Les ouvertures (14) des grilles (13) sont soit des ouvertures d'entrée E1 par lesquelles l'air est aspiré, soit des ouvertures de sortie E2 par lesquelles l'air est expulsé.

Les ouvertures d'entrée E1 sont positionnées sur la grille (13) inférieure, et les ouvertures de sortie E2 sont positionnées sur la grille (13) supérieure de la poignée (1).

La surface totale S2 représente la surface cumulée de toutes les ouvertures (14) de sortie E2 et la surface totale S1 représente la surface cumulée de toutes les ouvertures (14) d'entrée E1. Afin de dimensionner le nombre et la taille de ces ouvertures (14) pour que le rendement du générateur (3) thermoélectrique soit optimal, il faut que la surface totale S2 soit égale à trois fois la longueur L, qui représente la longueur cumulée des ailettes (40). Toujours dans l'optique de rendement maximal, la surface totale S1 doit être supérieure à la surface totale S2.

L'espace offert par la cavité (11) permet de contenir différents éléments nécessaires à la mise en œuvre de l'invention.

Ainsi la poignée (1) comprend un générateur (3) thermoélectrique qui est positionné dans la cavité (11) ou à proximité de celle ci. Celui-ci est constitué d'au moins un module thermoélectrique qui peut être un module Peltier. Dans ce cas de figure, il présente deux surfaces (30, 31) de contact. Une première (30) surface de contact, dite chaude, est mise en contact avec une source de chaleur alors que la seconde (31) surface de contact, dite froide, est quant à elle mise en contact avec une source froide.

Comme cela est visible sur la figure 1, la poignée (1) comprend également une pièce (15) de jonction. Cette pièce (15) de jonction est métallique et conductrice de chaleur. La seconde (31) surface de contact du générateur (3) thermoélectrique est positionnée contre cette pièce (15) de jonction et les deux éléments sont reliés thermiquement.

De manière générale, on entend par « relié thermiquement » que le contact entre les éléments a une résistance thermique minimale.

En lien avec la figure 1, la poignée (1) peut également comprendre une pièce de couplage (16) thermique, dénommée pièce de couplage. Cette pièce de couplage (16) est reliée thermiquement à la première (30) surface de contact du générateur (3) thermoélectrique. Cette pièce de couplage (16) est prévue pour venir en contact avec la paroi (21) du récipient (2) lorsque la poignée (1) est fixée sur le récipient (2). L'intérêt de la pièce de couplage (16) est d'obtenir un couplage thermique performant entre le générateur (3) thermoélectrique et la source chaude.

De manière préférentielle cette pièce de couplage (16) est métallique et est faite soit en aluminium, soit en cuivre.

Dans une autre variante de réalisation de la poignée (1), non représentée, il n'y a pas de pièce de couplage (16) et la première (30) surface de contact du générateur (3) thermoélectrique est directement en contact avec la source chaude qui est la paroi (21) du récipient (2).

Comme cela est visible sur les figures 1 à 3, la poignée (1) comprend un dissipateur (4) thermique. Ce dissipateur (4) thermique est contenu dans la cavité (11) de la poignée (1).

Le dissipateur (4) thermique est relié thermiquement à la pièce (15) de jonction qui a pour fonction de maintenir le dissipateur (4) thermique.

Dans une variante de réalisation, non représentée, il n'y a pas de pièce (15) de jonction et le dissipateur (4) thermique est relié directement à la seconde (31) surface de contact du générateur (3) thermoélectrique.

Le dissipateur (4) thermique visible aux figures 1 à 3 est composé de deux ailettes (40) contenues dans la cavité (11) de la poignée (1). Elles sont orientées le long de la poignée (1) dans le sens longitudinal et s'étendent sur au moins les deux tiers de la longueur de la cavité (11). Ces deux ailettes (40) sont juxtaposées et préférentiellement parallèles entre elles. Entre les ailettes (40) il y a un espace qui peut être de quelques millimètres à un centimètre.

La hauteur, l'épaisseur et la longueur des ailettes (40) sont variables et sont fonction du rendement souhaité pour le générateur thermoélectrique. Cependant ces dimensions de hauteur, d'épaisseur et de longueur sont conditionnées par la largeur et la hauteur de la cavité (11) ou de la poignée (1).

Les ailettes (40) sont préférentiellement métalliques et conductrices de chaleur. Le métal peut être de l'aluminium ou encore du cuivre qui sont des bons conducteurs de chaleur.

Dans une variante, les ailettes (40) peuvent être des caloducs.

Par ailleurs, lorsque l'ensemble thermoélectrique, constitué du module thermoélectrique, de la pièce (15) de jonction, des ailettes (40) et de la pièce de couplage (16), est mis en contrainte contre la paroi (21) lorsque la poignée (1) est assemblée sur l'ustensile (2) via le système de fixation (22), il y a un risque de détérioration de certaines pièces.

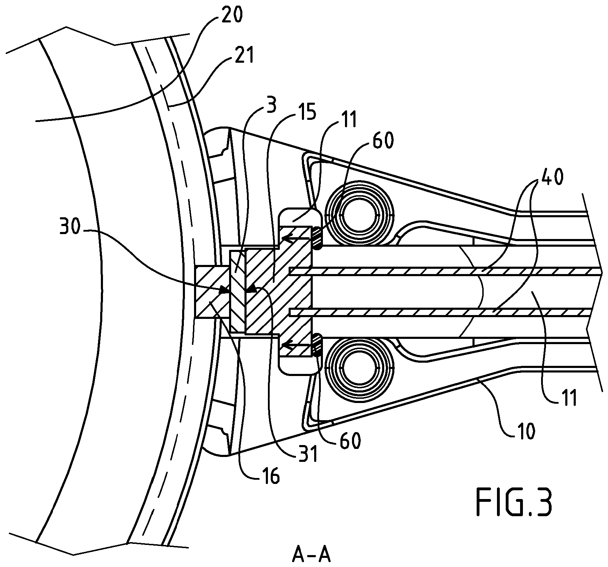

A cet effet et comme visible à la figure 3, des blocs élastomères (60) sont assemblés sur le système (22) de fixation de la poignée (1) pour limiter l'écrasement de la première (30) surface de contact ou de la pièce de couplage (16) mis en contrainte contre la paroi (21) lorsque la poignée (1) est fixée.

Comme visible à la figure 2, la poignée (1) peut également comprendre un dispositif électronique (50) relié au générateur (3) thermoélectrique. Ce dispositif électronique (50) peut être un afficheur (51) électronique ou un capteur électronique (52).

Ce capteur électronique (52) peut être, par exemple et de façon non limitative, un capteur de température.

La poignée (1) peut également comprendre un micro ventilateur (non représenté) relié au générateur (3) thermoélectrique afin d'être alimenté en courant et pour accélérer le refroidissement de la poignée.

L'invention consiste tout d'abord à établir un couplage thermique performant entre la première surface (30) de contact du générateur (3) thermoélectrique et la paroi (21) du récipient (2) de cuisson qui fait office de source chaude. Ceci est obtenu soit par la pièce de couplage (16) en aluminium qui maximise la surface de contact avec la paroi (21) du récipient (2) lorsque la poignée (1) est assemblée sous contrainte contre la paroi (21) via la fixation classique par goujon (22) ou rivets ou soit directement par contact entre la première surface (30) de contact du générateur (3) thermoélectrique et la paroi (21) du récipient (2) de cuisson.

Lors de la mise en chauffe du récipient (2), la paroi (21) en aluminium de celui-ci va progressivement s'échauffer ce qui va constituer la source chaude pour le générateur (3) thermoélectrique. Un flux thermique va alors s'établir et les ailettes (40) comprises dans la poignée (1) vont s'échauffer à leur tour. Une convection naturelle de l'air ambiant va se produire à l'intérieur de la poignée (1) au niveau de la cavité (11).

La convection va se faire à travers les ouvertures (14) de la grille (13) de protection. L'air froid va arriver au contact des ailettes (40) par les ouvertures (14) inférieures, va les refroidir et va ensuite ressortir par les ouvertures (14) supérieures.

Cette convection peut être accélérée par l'utilisation d'un micro ventilateur, non représenté, qui accélère le passage de l'air ambiant sur les ailettes (40).

Le but de cette convection est de créer une source froide dans la poignée (1) en permettant aux ailettes (40) de céder de la chaleur à l'air ambiant. Le fait d'avoir un volume de convection qui s'étend dans la poignée (1) et qui est déporté de la source chaude permet d'établir une source froide efficace même en régime permanent entre la paroi (21) du récipient (2) et l'air ambiant.

Le flux thermique qui va s'établir en régime permanent va ainsi traverser le module thermoélectrique et créer à ses bornes une tension électrique qui sera proportionnelle au flux thermique.

Ainsi si le flux thermique est nul la tension électrique sera nulle ce qui arrive quand les ailettes (40) n'évacuent pas suffisamment de chaleur c'est-à-dire que la source froide n'est pas établie.

Dans un cas où le récipient (2) est placé sur un foyer dissipant une puissance de 300 W, le flux thermique obtenu en régime permanent au travers du module thermoélectrique va de 3 W/cm² à 6 W/cm², ce qui correspond à une production électrique allant de 7,2 mW à 14 mW sous une plage de tension allant de 1,5 V à 2,7 V.

Lorsque la poignée (1) comprend un dispositif électronique (50) relié au générateur (3) thermoélectrique comme par exemple un afficheur (51) électronique, un capteur électronique (52) ou un micro ventilateur, une telle production électrique est suffisante pour alimenter en énergie ces différents dispositifs électroniques (50).

On comprendra que diverses modifications et/ou améliorations évidentes pour l'homme du métier peuvent être apportées au mode de réalisation de l'invention décrit dans la présente description sans sortir du cadre de l'invention défini par les revendications annexées.

## Revendications

1. Poignée (1) pour récipient (2) de cuisson ou pour couvercle de récipient de cuisson comprenant au moins un générateur (3) thermoélectrique qui est relié thermiquement à un dissipateur (4) thermique ladite poignée (1) comprenant une cavité (11) intérieure qui s'étend longitudinalement sur au moins un tiers de la longueur de la poignée (1) ladite poignée étant **caractérisée en ce que** le dissipateur (4) thermique s'étend longitudinalement dans la cavité (11) et dans au moins deux tiers de la longueur de la cavité (11).

2. Poignée (1) pour récipient (2) de cuisson ou pour couvercle de récipient de cuisson selon la revendication précédente **caractérisée en ce que** le dissipateur (4) thermique comprend une ou plusieurs ailettes (40).

3. Poignée (1) pour récipient (2) de cuisson ou pour couvercle de récipient de cuisson selon la revendication précédente **caractérisée en ce que** les ailettes (40) sont métalliques et sont soit en aluminium soit en cuivre.

4. Poignée (1) pour récipient (2) de cuisson ou pour couvercle de récipient de cuisson selon la revendication 2 **caractérisée en ce que** les ailettes (40) sont des caloducs.

5. Poignée (1) pour récipient (2) de cuisson ou pour couvercle de récipient de cuisson selon l'une des revendications précédentes **caractérisée en ce que** la cavité (11) comprend une ou plusieurs ouvertures (12) qui débouchent vers l'extérieur.

6. Poignée (1) pour récipient (2) de cuisson ou pour couvercle de récipient de cuisson selon la revendication précédente **caractérisée en ce que** la poignée (1) comprend une ou plusieurs grilles (13) de protection positionnées sur les une ou plusieurs ouverture (12).

7. Poignée (1) pour récipient (2) de cuisson ou pour couvercle de récipient de cuisson selon l'une des revendications précédente **caractérisée en ce que** la poignée comprend une pièce (15) de jonction entre le générateur (3) thermoélectrique et le dissipateur (4) thermique.

8. Poignée (1) pour récipient (2) de cuisson ou pour couvercle de récipient de cuisson selon l'une des revendications précédentes **caractérisée en ce que** la poignée (1) comprend un dispositif électronique (50) relié au générateur (3) thermoélectrique.

9. Poignée (1) pour récipient (2) de cuisson ou pour couvercle de récipient de cuisson selon la revendication précédente **caractérisée en ce que** le dispositif électronique (50) peut être un afficheur (51) électronique ou un capteur électronique (52).

10. Poignée (1) pour récipient (2) de cuisson ou pour couvercle de récipient de cuisson selon l'une des revendications précédentes **caractérisée en ce que** la poignée (1) comprend un micro ventilateur relié au générateur (3) thermoélectrique.

## Patentansprüche

1. Griff (1) für ein Kochgefäß (2) oder für einen Deckel eines Kochgefäßes, der mindestens einen thermoelektrischen Generator (3) umfasst, der thermisch mit einem Wärmeableiter (4) verbunden ist, wobei der Griff (1) einen Innenhohlraum (11) umfasst, der sich in Längsrichtung auf mindestens einem Drittel der Länge des Griffs (1) erstreckt, wobei der Griff **dadurch gekennzeichnet ist, dass** sich der Wärmeableiter (4) in Längsrichtung im Hohlraum (11) und in mindestens zwei Dritteln der Länge des Hohlraums (11) erstreckt.

2. Griff (1) für ein Kochgefäß (2) oder für einen Deckel eines Kochgefäßes nach dem vorstehenden Anspruch, **dadurch gekennzeichnet, dass** der Wärmeableiter (4) eine oder mehrere Rippen (40) umfasst.

3. Griff (1) für ein Kochgefäß (2) oder für einen Deckel eines Kochgefäßes nach dem vorstehenden Anspruch, **dadurch gekennzeichnet, dass** die Rippen (40) metallisch sind und entweder aus Aluminium oder aus Kupfer sind.

4. Griff (1) für ein Kochgefäß (2) oder für einen Deckel eines Kochgefäßes nach Anspruch 2, **dadurch gekennzeichnet, dass** es sich bei den Rippen (40) um Wärmeleitrohre handelt.

5. Griff (1) für ein Kochgefäß (2) oder für einen Deckel eines Kochgefäßes nach einem der vorstehenden Ansprüche, **dadurch gekennzeichnet, dass** der Hohlraum (11) eine oder mehrere Öffnungen (12) umfasst, die nach außen münden.

6. Griff (1) für ein Kochgefäß (2) oder für einen Deckel eines Kochgefäßes nach dem vorstehenden Anspruch, **dadurch gekennzeichnet, dass** der Griff (1) ein oder mehrere Schutzgitter (13) umfasst, die auf der einen oder den mehreren Öffnungen (12) positioniert sind.

7. Griff (1) für ein Kochgefäß (2) oder für einen Deckel eines Kochgefäßes nach einem der vorstehenden Ansprüche, **dadurch gekennzeichnet, dass** der Griff ein Verbindungsstück (15) zwischen dem thermoelektrischen Generator (3) und dem Wärmeableiter (4) umfasst.

8. Griff (1) für ein Kochgefäß (2) oder für einen Deckel eines Kochgefäßes nach einem der vorstehenden Ansprüche, **dadurch gekennzeichnet, dass** der Griff (1) eine elektronische Vorrichtung (50) umfasst, die mit dem thermoelektrischen Generator (3) verbunden ist.

9. Griff (1) für ein Kochgefäß (2) oder für einen Deckel eines Kochgefäßes nach dem vorstehenden Anspruch, **dadurch gekennzeichnet, dass** es sich bei der elektronischen Vorrichtung (50) um eine elektronische Anzeige (51) oder einen elektronischen Sensor (52) handeln kann.

10. Griff (1) für ein Kochgefäß (2) oder für einen Deckel eines Kochgefäßes nach einem der vorstehenden Ansprüche, **dadurch gekennzeichnet, dass** der Griff (1) einen Mikrolüfter umfasst, der mit dem thermoelektrischen Generator (3) verbunden ist.

## Claims

1. Handle (1) for a cooking vessel (2) or for a cooking vessel lid comprising at least one thermoelectric generator (3) which is thermally connected to a heat sink (4), said handle comprising an inner cavity (11) which extends longitudinally over at least one third of the length of the handle (1), said handle being **characterised in that** the heat sink (4) extends longitudinally into the cavity (11) and into at least two-thirds of the length of the cavity (11).

2. Handle (1) for a cooking vessel (2) or for a cooking vessel lid according to the preceding claim, **characterised in that** the heat sink (4) comprises one or more fins (40).

3. Handle (1) for a cooking vessel (2) or for a cooking vessel lid according to the preceding claim, **characterised in that** the fins (40) are metal and are made either of aluminium or of copper.

4. Handle (1) for a cooking vessel (2) or for a cooking vessel lid according to claim 2, **characterised in that** the fins (40) are heat pipes.

5. Handle (1) for a cooking vessel (2) or for a cooking vessel lid according to one of the preceding claims, **characterised in that** the cavity (11) comprises one or more openings (12) which lead to the outside.

6. Handle (1) for a cooking vessel (2) or for a cooking vessel lid according to the preceding claim, **characterised in that** the handle (1) comprises one or more protective grilles (13) positioned on one or more openings (12).

7. Handle (1) for a cooking vessel (2) or for a cooking vessel lid according to one of the preceding claims, **characterised in that** the handle comprises a joining part (15) between the thermoelectric generator (3) and the heat sink (4).

8. Handle (1) for a cooking vessel (2) or for a cooking vessel lid according to one of the preceding claims, **characterised in that** the handle (1) comprises an electronic device (50) connected to the thermoelectric generator (3).

9. Handle (1) for a cooking vessel (2) or for a cooking vessel lid according to the preceding claim, **characterised in that** the electronic device (50) can be an electronic display unit (51) or an electronic sensor (52).

10. Handle (1) for a cooking vessel (2) or for a cooking vessel lid according to one of the preceding claims, **characterised in that** the handle (1) comprises a micro fan connected to the thermoelectric generator (3).
